# FASCICULE DE BREVET EUROPEEN

(11) **EP 3 416 238 B1**
(45) Date de publication et mention de la délivrance du brevet: **27.10.2021**
(21) Numéro de dépôt: 18177476.1
(22) Date de dépôt: 13.06.2018
(51) Int. Cl.: H01Q 1/28, H01Q 1/00, H01Q 25/00, H01Q 21/00, H01Q 19/17, H03F 1/52, H03F 3/60, H03F 3/68, H04B 7/185, H01Q 21/06

(54) **ASSEMBLAGE D'ÉMISSION ET DE RÉCEPTION POUR UNE ANTENNE MULTIFAISCEAUX ET ANTENNE MULTIFAISCEAUX**
SENDE- UND EMPFANGSANORDNUNG FÜR EINE MEHRFACHSTRAHLANTENNE, UND MEHRFACHSTRAHLANTENNE
TRANSMISSION AND EMISSION ASSEMBLY FOR A MULTIBEAM ANTENNA AND MULTIBEAM ANTENNA

(30) Priorité: 13.06.2017 FR 1700620
(43) Date de publication de la demande: 19.12.2018
(73) Titulaire: THALES, 92400 Courbevoie (FR)
(72) Inventeur: BOSSHARD, Pierre, 31037 TOULOUSE Cedex 1 (FR); MANGENOT, Cyril Jean Benoit, 2242 LB Wassenaar (NL); MICHARD, Fréderic, 31037 TOULOUSE Cedex 1 (FR)
(74) Mandataire: Lavoix

(56) Documents cités:
- US-A1- 2005 052 333
- US-A1- 2014 194 293
- US-B1- 7 161 549
- Teresa M. Braun: "Satellite Communications: Payload and System" In: "Satellite Communications: Payload and System", 1 janvier 2012 (2012-01-01), John Wiley, XP055451624, * figure 4.27 * * Section 4.6.2 * * Section 2.2.1.6 *

## Description

La présente invention concerne un assemblage d'émission et de réception pour une antenne multifaisceaux.

La présente invention concerne également une antenne multifaisceaux comportant un tel assemblage.

De manière connue en soi, le terme « antenne multifaisceaux » désigne une antenne comportant plusieurs éléments rayonnants. Chacun de ces éléments est apte à recevoir et/ou à émettre un faisceau d'ondes électromagnétiques présentant un signal élémentaire qui fait partie d'un signal plus complexe reçu par l'antenne ou destiné à être émis par celle-ci.

Certaines antennes multifaisceaux, comme notamment celles utilisées dans le domaine des télécommunications par satellite, utilisent un grand nombre d'éléments rayonnants ce qui permet d'augmenter les performances techniques de ces antennes.

À cet effet, on peut par exemple citer des antennes multifaisceaux telles que décrites dans les documents US 2005/052333 A1 et US 2014/194293 A1.

De manière générale, dans ce type d'antennes multifaisceaux, les éléments rayonnants sont disposés en regard d'un réflecteur situé à l'extérieur du satellite et sont reliés aux autres composants de l'antenne par des guides d'ondes présentant des structures rigides.

Par ailleurs, il est habituel de placer ces autres composants dans la partie interne du satellite, c'est-à-dire dans sa charge utile. Cela a notamment pour but d'isoler thermiquement les éléments rayonnants qui présentent généralement une zone dite chaude de l'antenne des autres composants qui doivent eux rester dans une zone dite froide, afin de minimiser les pertes de performances de l'antenne.

Parmi les composants précités, on distingue notamment un réseau de distribution de guides d'ondes en émission permettant de former une pluralité de signaux élémentaires à émettre via les éléments rayonnants et un réseau de distribution de guides d'ondes en réception permettant de traiter des signaux élémentaires reçus par les éléments rayonnants.

Le réseau de distribution de guides d'ondes en réception comporte généralement une pluralité d'amplificateurs permettant alors d'amplifier les signaux élémentaires reçus par les éléments rayonnants.

On conçoit alors qu'avec l'augmentation du nombre d'éléments rayonnants, l'architecture d'une telle antenne multifaisceaux se complique considérablement.

En effet, lorsque ce nombre augmente, il est nécessaire d'augmenter le nombre de guides d'ondes ce qui se traduit par une augmentation de la complexité de routage des guides d'ondes jusqu'aux réseaux de distribution correspondants et plus généralement, par une augmentation de coûts de l'antenne. Cette complexité peut par ailleurs dégrader les performances de l'antenne multifaisceaux.

La présente invention a pour but de proposer un assemblage pour une antenne multifaisceaux permettant de réduire l'utilisation de guides d'ondes même lorsque le nombre d'éléments rayonnants devient important et ceci sans dégradation des performances de l'antenne.

À cet effet, la présente invention a pour objet un assemblage d'émission et de réception conforme à la revendication 1.

Suivant d'autres aspects avantageux de l'invention, l'assemblage comprend une ou plusieurs des caractéristiques des revendications 2 à 10, prise(s) isolément ou suivant toutes les combinaisons techniquement possibles.

La présente invention a également pour objet une antenne multifaisceaux conforme à la revendication 11.

Suivant d'autres aspects avantageux de l'invention, l'antenne comprend la caractéristique de la revendication 12.

Ces caractéristiques et avantages de l'invention apparaitront à la lecture de la description qui va suivre, donnée uniquement à titre d'exemple non limitatif, et faite en référence aux dessins annexés, sur lesquels :
- la figure 1 est une vue schématique d'un satellite comportant une antenne multifaisceaux selon l'invention ;
- la figure 2 est une vue schématique de l'antenne multifaisceaux de la figure 1, l'antenne multifaisceaux comportant un boitier comprenant notamment un réseau de distribution en émission et un réseau de distribution en réception ;
- la figure 3 est une vue schématique détaillée du boitier de la figure 2 ; et
- la figure 4 est une vue schématique détaillée du réseau de distribution en réception du boitier de la figure 3.

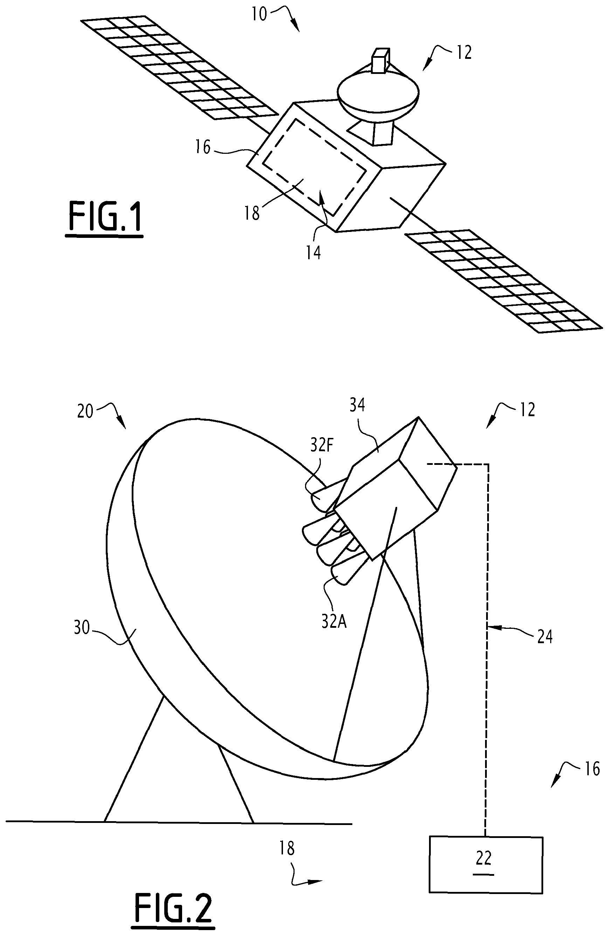

Le satellite 10 de la figure 1 est par exemple un satellite de télécommunications disposé sur une orbite terrestre et apte à communiquer avec un ou plusieurs centres terrestres en émettant et en recevant des signaux électromagnétiques via l'antenne multifaisceaux 12.

Le satellite 10 présente une partie interne 14 délimitée par un corps de satellite 16. La partie interne 14 comporte notamment une charge utile 18.

De manière connue en soi, la charge utile 18 comporte des équipements assurant la mission du satellite 12 et est protégée, notamment thermiquement, de l'espace extérieur par le corps 16.

Dans la suite de la description, par « extérieur du satellite », on comprend l'espace à l'extérieur du corps de satellite 16.

L'antenne 12 est disposée partiellement à l'extérieur du satellite 10 et partiellement dans sa partie interne 14 comme cela sera expliqué par la suite.

En référence à la figure 2, l'antenne 12 comporte un assemblage 20 d'émission et de réception de signaux électromagnétiques, un module de communication 22 et des moyens de raccordement 24 du module de communication 22 à l'assemblage 20.

Dans l'exemple décrit, les moyens de raccordement 24 se présentent sous la forme de câbles coaxiaux.

Le module de communication 22 est disposé dans la charge utile 18 du satellite 12. Ce module 22 se présente sous la forme d'un composant électronique raccordé par exemple à un calculateur de bord du satellite 10.

Notamment, le module de communication 22 est apte à générer un signal d'émission à partir par exemple des données numériques transmises à ce module 22 par le calculateur de bord et à transmettre ce signal d'émission à l'assemblage 20 via les moyens de raccordement 24.

Le module de communication 22 est apte en outre à recevoir des signaux électromagnétiques reçus par l'assemblage 20, à les transformer en données numériques et à transmettre ces données numériques vers le calculateur de bord.

L'assemblage 20 est disposé à l'extérieur du satellite 10, c'est-à-dire à l'extérieur du corps de satellite 16, et comprend un réflecteur 30, une pluralité d'éléments rayonnants 32A à 32F disposés en regard du réflecteur 30 et un boitier 34 relié d'une part aux éléments rayonnants 32A à 32F et de l'autre part, au module de communication 22 via les moyens de raccordement 24.

Le réflecteur 30 est connu en soi. Ainsi, par exemple, il présente une forme parabolique orientée vers la surface terrestre.

Les éléments rayonnantes 32A à 32F sont par exemple disposés sensiblement dans le foyer du réflecteur 30. Dans cette position, ils sont maintenus par des moyens de support adaptés et connus en soi.

Chaque élément rayonnant 32A à 32F se présente sous la forme d'un cornet d'émission et/ou de réception de signaux électromagnétiques. Chaque cornet a une forme allongée et présente une extrémité large et une extrémité rétrécie. Au moins l'un des cornets, par exemple le cornet correspondant à l'élément rayonnant 32C, est allongé suivant un axe, dit axe de cornet X.

Les cornets présentent une forme identique ou bien des formes différentes.

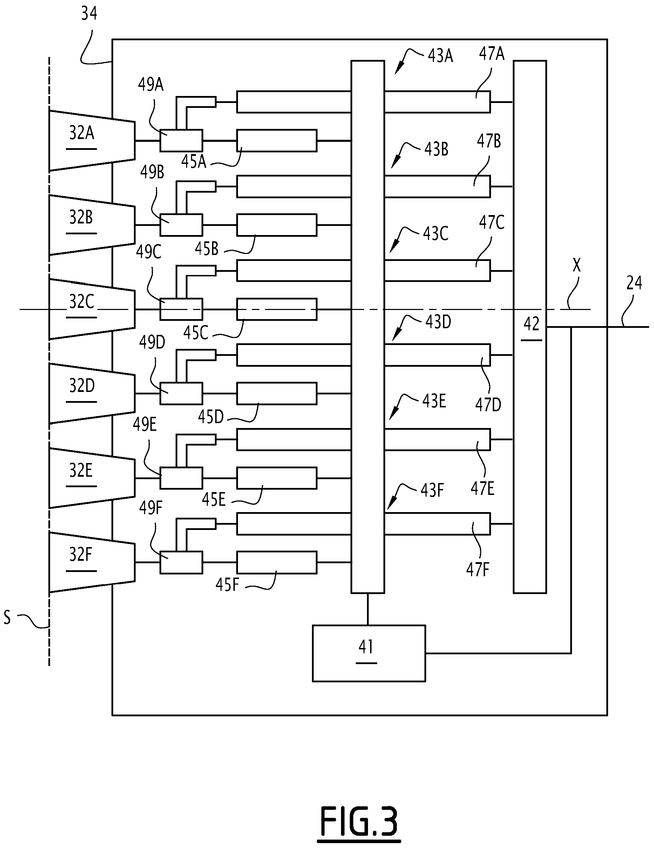

L'ensemble des cornets sont disposés sur une surface plane du boitier 34 orientée vers le réflecteur 30 et sont par exemple fixés sur cette surface par leurs extrémités rétrécies. Les extrémités larges des cornets font donc saillie par rapport à cette surface et forment une surface rayonnante S visible sur la figure 3.

Cette surface rayonnante S est par exemple sensiblement plane et est perpendiculaire à l'axe de cornet X. Dans ce cas, tous les cornets sont allongés suivant l'axe de cornet X.

Dans l'exemple décrit ci-dessous, les cornets et donc les éléments rayonnants 32A à 32F, sont au nombre de six.

Le contenu du boitier 34 sera désormais détaillé en référence à la figure 3.

Il est à noter que sur cette figure 3, ce contenu est illustré sous la forme d'un diagramme, c'est-à-dire, sans représenter les formes et positions physiques réelles de différents éléments.

En particulier, en référence à la figure 3, le boitier 34 comprend un réseau de distribution en émission 41, un réseau de distribution en réception 42 et pour chaque élément rayonnant 32A à 32F, une voie de transmission 43A à 43F reliant l'élément rayonnant 32A à 32F correspondant au réseau de distribution en émission 41 et/ou au réseau de distribution en réception 42.

Dans l'exemple de réalisation de la figure 3, les voies de transmission 43A à 43F relie chaque élément rayonnant 32A à 32F au réseau de distribution en émission 41 et au réseau de distribution en réception 42.

Pour ce faire, chaque voie de transmission 43A à 43F comprend un guide d'ondes d'émission 45A à 45F reliant l'élément rayonnant 32A à 32F correspondant au réseau de distribution en émission 41, et un guide d'ondes de réception 47A à 47F reliant l'élément rayonnant 32A à 32F correspondant au réseau de distribution en réception 42.

Par ailleurs, chaque voie de transmission 43A à 43F comprend en outre une chaine radiofréquence 49A à 49F reliant les guides d'ondes de réception 47A à 47F et d'émission 45A à 45F correspondant au même élément rayonnant 32A à 32F, à cet élément rayonnant 32A à 32F.

Le réseau de distribution en émission 41 comporte une pluralité de ports d'émission reliés aux éléments rayonnants 32A à 32F via les guides d'ondes d'émission 45A à 45F correspondants.

Le réseau de distribution en émission 41 est relié en outre au module de communication 22 via les moyens de raccordement 24 et apte à recevoir chaque signal électromagnétique issu de ce module de communication 22 pour l'émettre via les éléments rayonnants 32A à 32F sous la forme de signaux élémentaires.

Le réseau de distribution en émission 41 présente ainsi un composant électronique disposé entre la surface rayonnante S et le réseau de distribution en réception 42.

Autrement dit, le réseau de distribution en émission 41 est disposé plus près à la surface rayonnante S que le réseau de distribution en réception 42.

En outre, les guides d'ondes d'émission 45A à 45F présentent une longueur plus courte que celle des guides d'ondes de réception 47A à 47F.

Tout comme le réseau de distribution en émission 41, le réseau de distribution en réception 42 comporte une pluralité de ports de réception reliés aux éléments rayonnants 32A à 32F via les guides d'ondes de réception 47A à 47F correspondants.

Le réseau de distribution en réception 42 est relié également au module de communication 22 via les moyens de raccordement 24 et apte à recevoir des signaux élémentaires issus des éléments rayonnants 32A à 32F correspondants, à les amplifier et à les transmettre vers le module de communication 22 via les moyens de raccordement 24.

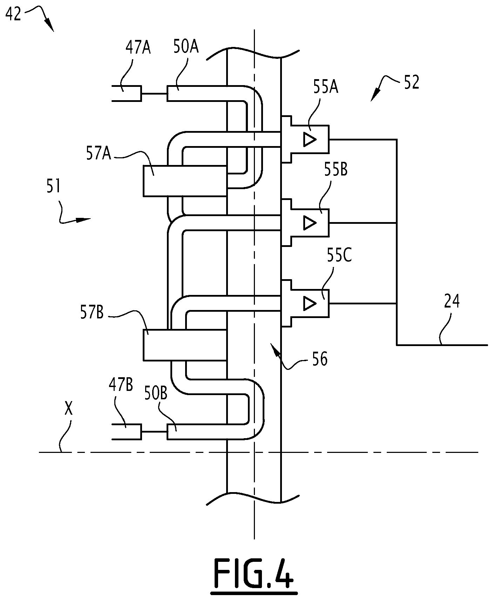

Le réseau de distribution en réception 42 sera désormais expliqué plus en détail en référence à la figure 4 illustrant une coupe d'une partie de ce réseau de distribution en réception 42.

En effet, sur cette figure 4, seulement deux ports de réception 50A et 50B raccordés respectivement aux guides d'ondes de réception 47A et 47B, sont visibles.

En outre, comme cela est également visible sur la figure 4, le réseau de distribution en réception 42 se présente sous la forme d'une plaque disposée transversalement par rapport à l'axe de cornet X et présentant une première surface 51 orientée vers les éléments rayonnants 32A à 32F et une deuxième surface 52 opposée à la première surface 51. Les ports de réception 50A et 50B sont disposés sur la première surface 51 par exemple selon des positions prédéterminées.

La plaque est par exemple réalisée en couches empilées.

Le réseau de distribution en réception 42 comporte en outre une pluralité d'amplificateurs faible bruit 55A à 55C disposés sur la deuxième surface 52 et des moyens d'interconnexion 56 disposés à travers la plaque et raccordant chaque port de réception 50A, 50B à au moins un amplificateur faible bruit 55A à 55C. Sur la figure 4, seuls trois amplificateurs 55A à 55C sont visibles.

Chaque amplificateur faible bruit 55A à 55C est connu en soi et présente par exemple un amplificateur de type LNA (de l'anglais « Low Noise Amplifier »).

Les moyens d'interconnexion 56 comportent des guides d'ondes et une pluralité de commutateurs électromécaniques 57A, 57B intégrés dans les guides d'ondes. Chaque commutateur 57A, 57B est pilotable pour commuter l'interconnexion du port de réception 50A, 50B correspondant entre au moins deux amplificateurs faible bruit 55A à 55C différents. Sur la figure 4, seuls deux commutateurs 57A et 57B sont visibles.

Le pilotage des commutateurs 57A, 57B s'effectue par exemple par des signaux spécifiques transmis par le module de communication 22 via les moyens de raccordement 24.

Selon un mode de réalisation particulièrement avantageux, les moyens d'interconnexion 56 forment une boucle de redondance permettant de substituer au moins certains amplificateurs 55A à 55C défaillants par des amplificateurs 55A à 55C redondants.

En particulier, la boucle de redondance et notamment la disposition des guides d'ondes correspondants à travers la plaque et le nombre de commutateurs 57A, 57B, ainsi que le nombre d'amplificateurs faible bruit 55A à 55C sont adaptés pour assurer la redondance en N:N+P, où N signifie le nombre total de ports de réception reliés à des éléments rayonnants 32A à 32F et P signifie le nombre de pannes des amplificateurs faible bruit nécessaire pour qu'un port de réception devienne inutilisable.

En particulier, dans l'exemple de réalisation de la figure 3, le nombre N est égal à six et le nombre P est égal à trois. Dans ce cas, le nombre total d'amplificateurs faible bruit est égal à neuf.

Finalement, le réseau de distribution en réception 42 comporte en outre un système de contrôle thermique (non-illustré) comportant par exemple une pluralité de canaux emplis d'un fluide et disposés sur les première et/ou deuxième surfaces 51 et 52, ou encore à l'intérieur de la plaque.

Ce système de contrôle thermique permet de générer une zone à proximité du réseau de distribution en réception 42 dans laquelle la température est contrôlée. Cette zone est dite zone froide par opposition à une zone, dite chaude, à proximité des éléments rayonnants 32A à 32F.

Par ailleurs, selon un exemple de réalisation, les guides d'ondes et notamment les guides d'ondes de réception 47A à 47F sont faits d'un matériau thermo-isolant. Ceci permet alors d'isoler davantage le réseau de distribution en réception 42 des éléments rayonnants 32A à 32F.

Plus généralement, selon un exemple de réalisation, le boitier 34 comporte un système de contrôle thermique indépendant couplant un réseau de caloducs à un radiateur. Ce système est par exemple couplé à un système de contrôle thermique du satellite 12.

On conçoit alors que la présente invention présente un certain nombre d'avantages.

Tout d'abord, la disposition du réseau de distribution en réception et notamment des amplificateurs faible bruit au plus près des éléments rayonnants permet de réduire considérablement l'utilisation des guides d'ondes. Ceci rend alors possible le cheminement des signaux électromagnétiques jusqu'au module de communication via des simples câbles coaxiaux qui sont plus flexibles, moins encombrants et moins couteux que les guides d'ondes habituellement utilisés dans ces cas.

De plus, un contrôle thermique mis en œuvre dans le voisinage du réseau de distribution en réception permet de disposer ce réseau au plus près des éléments rayonnants sans dégrader les performances de l'antenne.

En outre, la séparation des voies de réception et d'émission à l'intérieur du boitier contenant les réseaux de distribution en émission et en réception, permet de configurer la boucle de redondance du réseau de distribution en réception de la manière souhaitée. En particulier, dans l'exemple décrit, la redondance en N:N+P a été obtenue.

Bien entendu, la présente invention ne se limite pas au mode de réalisation décrit précédemment.

En particulier, l'invention reste applicable à tout type d'antennes multifaisceaux et non seulement aux antennes multifaisceaux embarquées dans un satellite. Ainsi, il est possible de mettre en œuvre l'invention dans des antennes multifaisceaux embarquées dans tout autre type d'engin mobile ou encore disposées de manière fixe par exemple sur la surface terrestre.

## Revendications

1. Assemblage (20) d'émission et de réception pour une antenne multifaisceaux (12), l'antenne (12) comportant en outre un module de communication (22), l'assemblage (22) comprenant :
- une pluralité d'éléments rayonnants (32A,...,32F) formant une surface rayonnante (S), chaque élément rayonnant (32A,...,32F) étant apte à émettre et à recevoir des signaux électromagnétiques en aval de la surface rayonnante (S) ;
- un réseau de distribution en émission (41) disposé en amont de la surface rayonnante (S) et comportant une pluralité de ports d'émission, chaque port d'émission étant relié à un élément rayonnant (32A,...,32F) par un guide d'ondes d'émission (45A,...,45F) et apte à émettre via l'élément rayonnant (32A,...,32F) correspondant, un signal électromagnétique formé à partir d'un signal électromagnétique issu du module de communication (22) ;
- un réseau de distribution en réception (42) disposé en amont de la surface rayonnante (S) et comportant une pluralité de ports de réception (50A, 50B), une pluralité d'amplificateurs faible bruit (55A, 55B, 55C) et des moyens d'interconnexion (56) de chaque port de réception (50A, 50B) à au moins un amplificateur faible bruit (55A, 55B, 55C), chaque port de réception (50A, 50B) étant relié à un élément rayonnant (32A,...,32F) par un guide d'ondes de réception (47A,...,47F) et apte à recevoir chaque signal électromagnétique issu de l'élément rayonnant (32A,...,32F) correspondant et à le transmettre à l'amplificateur faible bruit (55A, 55B, 55C) associé pour obtenir un signal électromagnétique amplifié destiné au module de communication (22) ;
le réseau de distribution en réception (42) et les éléments rayonnants (32A,32F) sont découplés thermiquement, **caractérisé en ce que** :
- le réseau de distribution en émission (41) et le réseau de distribution en réception (42) sont distincts l'un de l'autre et sont disposés dans un même boitier (34) distinct du module de communication (22) ; et **en ce que** les guides d'ondes de réception (47A,...,47F) sont faits d'un matériau thermo-isolant apte à isoler thermiquement les amplificateurs faible bruit (55A, 55B, 55C) des éléments rayonnants (32A,...,32F).

2. Assemblage (20) selon la revendication 1, dans lequel le réseau de distribution en réception (42) est relié au module de communication (22) par des câbles coaxiaux.

3. Assemblage (20) selon la revendication 1 ou 2, dans lequel les éléments rayonnants (32A,...,32F) se présentent sous la forme de cornets, au moins l'un des cornets étant allongé selon un axe de cornet (X).

4. Assemblage (20) selon la revendication 3, dans lequel le réseau de distribution en réception (42) se présente sous la forme d'une plaque disposée transversalement par rapport à l'axe de cornet (X) et présentant une première surface (51) orientée vers les éléments rayonnants (32A,...,32F) et une deuxième surface (52) opposée à la première surface (51), les ports de réception (50A, 50B) étant disposés sur la première surface (51) selon des positions prédéterminées.

5. Assemblage (20) selon la revendication 3 ou 4, dans lequel le réseau de distribution en émission (41) est disposé entre les éléments rayonnants (32A,...,32F) et le réseau de distribution en réception (42) en suivant l'axe de cornet (X).

6. Assemblage (20) selon l'une quelconque des revendications précédentes, dans lequel les moyens d'interconnexion (56) comportent une pluralité de commutateurs électromécaniques (57A, 57B) pilotables pour commuter l'interconnexion de chaque port de réception (50A, 50B) entre à au moins deux amplificateurs faible bruit différents (55A, 55B, 55C).

7. Assemblage (20) selon la revendication 6, dans lequel :
- les moyens d'interconnexion (56) forment une boucle de redondance ;
- la boucle de redondance et le nombre d'amplificateurs faible bruit (55A, 55B, 55C) sont adaptés pour assurer la redondance en N:N+P, où N signifie le nombre total de ports de réception (50A, 50B) reliés aux éléments rayonnants (32A,...,32F) et P signifie le nombre de pannes des amplificateurs faible bruit (55A, 55B, 55C) nécessaire pour qu'un port de réception (50A, 50B) devienne inutilisable.

8. Assemblage (20) selon l'une quelconque des revendications précédentes, dans lequel le réseau de distribution en réception (42) comporte en outre un système de contrôle thermique.

9. Assemblage (20) selon la revendication 8 prise en combinaison avec la revendication 4, dans lequel le système de contrôle thermique comporte une pluralité de canaux emplis d'un fluide et disposés sur les première et/ou deuxième surfaces (51, 52).

10. Assemblage (20) selon l'une quelconque des revendications précédentes, comportant en outre une pluralité de chaines radiofréquence (49A,...,49F), chaque chaine radiofréquence (49A,...,49F) étant associée à un élément rayonnant (32A,...,32F) et reliant cet élément rayonnant (32A,...,32F) au guide d'ondes de réception (47A,...,47F) correspondant et/ou au guide d'ondes d'émission (45A,...,45F) correspondant.

11. Antenne multifaisceaux (12) comportant un module de communication (22) et un assemblage (20) d'émission et de réception, l'assemblage (20) d'émission et de réception étant selon l'une quelconque des revendications précédentes.

12. Antenne (12) selon la revendication 11, dans laquelle, lorsqu'elle est mise sur un engin spatial (12), l'engin spatial comportant une charge utile, le boitier (34) comprenant le réseau de distribution en émission (41) et le réseau de distribution en réception (42) est disposé à l'extérieur de l'engin spatial (12) et le module de communication (22) est disposé dans la charge utile (18) de l'engin spatial (12).

## Patentansprüche

1. Anordnung (20) zum Senden und Empfangen für eine Mehrstrahlantenne (12), die Antenne (12) ferner umfassend ein Kommunikationsmodul (22), die Anordnung (22) umfassend:
- eine Vielzahl von Strahlungselementen (32A, ..., 32F), die eine Strahlungsfläche (S) bilden, wobei jedes Strahlungselement (32A, ..., 32F) angepasst ist, um stromabwärts von der Strahlungsfläche (S) elektromagnetische Signale zu senden und zu empfangen;
- ein Emissionsverteilernetz (41), das stromaufwärts von der Strahlungsfläche (S) angeordnet ist und eine Vielzahl von Emissionsanschlüssen umfasst, wobei jeder Emissionsanschluss durch einen Emissionshohlleiter (45A, ..., 45F) mit einem Strahlungselement (32A, ..., 32F) verbunden ist und angepasst ist, um über das entsprechende Strahlungselement (32A, ..., 32F) ein elektromagnetisches Signal auszusenden, das aus einem elektromagnetischen Signal gebildet wird, das von dem Kommunikationsmodul (22) ausgegeben wird;
- ein Empfangsverteilernetz (42), das stromaufwärts von der Strahlungsfläche (S) angeordnet ist und eine Vielzahl von Empfangsanschlüssen (50A, 50B), eine Vielzahl von rauscharmen Verstärkern (55A, 55B, 55C) und Einrichtungen (56) zum Verbinden von jedem Empfangsanschluss (50A, 50B) mit mindestens einem rauscharmen Verstärker (55A, 55B, 55C) umfasst, wobei jeder Empfangsanschluss (50A, 50B) durch einen Empfangshohlleiter (47A, ..., 47F) mit einem Strahlungselement (32A, ..., 32F) verbunden ist und angepasst ist, um jedes elektromagnetische Signal zu empfangen, das von dem entsprechenden Strahlungselement (32A, ..., 32F) ausgegeben wird, und es an den assoziierten rauscharmen Verstärker (55A, 55B, 55C) zu übertragen, um ein verstärktes elektromagnetisches Signal zu erlangen, das für das Kommunikationsmodul (22) bestimmt ist;
das Empfangsverteilernetz (42) und die Strahlungselemente (32A, 32F) thermisch entkoppelt sind, **dadurch gekennzeichnet, dass**:
- das Emissionsverteilernetz (41) und das Empfangsverteilernetz (42) voneinander getrennt sind und in einem einzigen Gehäuse (34) getrennt von dem Kommunikationsmodul (22) angeordnet sind; und
dass die Empfangshohlleiter (47A, ..., 47F) aus einem wärmeisolierenden Material gefertigt sind, das angepasst ist, um die rauscharmen Verstärker (55A, 55B, 55C) thermisch von den Strahlungselementen (32A, ..., 32F) zu isolieren.

2. Anordnung (20) nach Anspruch 1, wobei das Empfangsverteilernetz (42) über Koaxialkabel mit dem Kommunikationsmodul (22) verbunden ist.

3. Anordnung (20) nach Anspruch 1 oder 2, wobei die Strahlungselemente (32A, ..., 32F) die Form von Hörnern aufweisen, wobei mindestens eines der Hörner entlang einer Hornachse (X) gestreckt ist.

4. Anordnung (20) nach Anspruch 3, wobei das Empfangsverteilerfeld (42) die Form einer quer zu der Hornachse (X) angeordneten Platte aufweist, die eine erste, den Strahlungselementen (32A, ..., 32F) zugewandte Fläche (51) aufweist und eine zweite, der ersten Fläche (51) gegenüberliegende Fläche (52) aufweist, wobei die Empfangsöffnungen (50A, 50B) an der ersten Fläche (51) gemäß vorbestimmten Positionen angeordnet sind.

5. Anordnung (20) nach Anspruch 3 oder 4, wobei das Emissionsverteilernetz (41) zwischen den Strahlungselementen (32A, ..., 32F) und dem Empfangsverteilernetz (42) entlang der Hornachse (X) angeordnet ist.

6. Anordnung (20) nach einem der vorherigen Ansprüche, wobei die Verbindungseinrichtungen (56) eine Vielzahl von steuerbaren elektromechanischen Schaltern (57A, 57B) zum Umschalten der Verbindung von jedem Empfangsanschluss (50A, 50B) zwischen mindestens zwei verschiedenen rauscharmen Verstärkern (55A, 55B, 55C) umfassen.

7. Anordnung (20) nach Anspruch 6, wobei:
- die Verbindungseinrichtungen (56) eine Redundanzschleife bilden;
- die Redundanzschleife und die Anzahl der rauscharmen Verstärker (55A, 55B, 55C) angepasst sind, um eine Redundanz in der Form von N:N+P bereitzustellen, wobei N die Gesamtzahl der mit den Strahlungselementen (32A, ..., 32F) verbundenen Empfangsanschlüsse (50A, 50B) und P die Anzahl der Ausfälle der rauscharmen Verstärker (55A, 55B, 55C) bedeutet, die erforderlich sind, damit ein Empfangsanschluss (50A, 50B) unbrauchbar wird.

8. Anordnung (20) nach einem der vorherigen Ansprüche, wobei das Empfangsverteilernetz (42) ferner ein thermisches Kontrollsystem umfasst.

9. Anordnung (20) nach Anspruch 8 in Kombination mit Anspruch 4, wobei das thermische Kontrollsystem eine Vielzahl von mit Flüssigkeit gefüllten Kanälen umfasst, die auf der ersten und/oder der zweiten Oberfläche (51, 52) angeordnet sind.

10. Anordnung (20) nach einem der vorherigen Ansprüche, ferner umfassend eine Vielzahl von Hochfrequenzketten (49A, ..., 49F), wobei jede Hochfrequenzkette (49A, ..., 49F) mit einem Strahlungselement (32A, ..., 32F) assoziiert ist und dieses Strahlungselement (32A, ..., 32F) mit dem entsprechenden Empfangshohlleiter (47A, ..., 47F) und/oder mit dem entsprechenden Emissionshohlleiter (45A, ..., 45F) verbindet.

11. Mehrstrahlantenne (12), umfassend ein Kommunikationsmodul (22) und eine Anordnung (20) zum Senden und Empfangen, wobei die Anordnung (20) zum Senden und Empfangen nach einem der vorherigen Ansprüche gebildet ist.

12. Antenne (12) nach Anspruch 11, wobei das Gehäuse (34) umfassend das Emissionsverteilernetz (41) und das Empfangsverteilernetz (42) außerhalb des Raumfahrzeugs (12) angeordnet ist und das Kommunikationsmodul (22) in der Nutzlast (18) des Raumfahrzeugs (12) angeordnet ist, wenn es auf einem Raumfahrzeug (12) angeordnet ist, wobei das Raumfahrzeug eine Nutzlast aufweist.

## Claims

1. An emission and reception assembly (20) for a multibeam antenna (12), the antenna (12) further including a communication module (22), the assembly (22) comprising:
- a plurality of radiating elements (32A,...,32F) forming a radiating surface (S), each radiating element (32A,...,32F) being capable of emitting and receiving electromagnetic signals downstream from the radiating surface (S);
- an emission distribution network (41) arranged upstream from the radiating surface (S) and including a plurality of emission ports, each emission port being connected to a radiating element (32A,...,32F) by an emission waveguide (45A,...,45F) and able to emit, via the corresponding radiating element (32A,...,32F), an electromagnetic signal formed from an electromagnetic signal coming from the communication module (22);
- a reception distribution network (42) arranged upstream from the radiating surface (S) and including a plurality of reception ports (50A, 50B), a plurality of low-noise amplifiers (55A, 55B, 55C) and means (56) for interconnecting each reception port (50A, 50B, 50C) to at least one low-noise amplifier, each reception port (50A, 50B, 50C) being connected to a radiating element (32A,...,32F) by a reception waveguide (47A,...,47F) and able to receive each electromagnetic signal coming from the corresponding radiating element (32A,...,32F) and to send it to the associated low-noise amplifier (55A, 55B, 55C) to obtain an amplified electromagnetic signal intended for the communication module (22);
the reception distribution network (42) and the radiating elements (32A,...,32F) being thermally decoupled,
**characterized in that** the emission distribution network (41) and the reception distribution network (42) are distinct from one another and are arranged in a same housing (34) distinct from the communication module (22); and
**in that** the reception waveguides (47A,...,47F) are made from a thermally insulating material capable of thermally insulating the low-noise amplifiers (55A, 55B, 55C) from the radiating elements (32A,...,32F).

2. The assembly (20) according to claim 1, wherein the reception distribution network (42) is connected to the communication module (22) by coaxial cables.

3. The assembly (20) according to claim 1 or 2, wherein the radiating elements (32A,..., 32F) are in the form of horns, at least one of the horns being elongate along a horn axis (X).

4. The assembly (20) according to claim 3, wherein the reception distribution network (42) is in the form of a plate arranged transversely to the horn axis (X) and having a first surface (51) oriented toward the radiating elements (32A,..., 32F) and a second surface (52) opposite the first surface (51), the reception ports (50A, 50B) being arranged on the first surface (51) in predetermined positions.

5. The assembly (20) according to claim 3 or 4, wherein the emission distribution network (41) is arranged between the radiating elements (32A,...,32F) and the reception distribution network (42) along the horn axis (X).

6. The assembly (20) according to any one of the preceding claims, wherein the interconnection means (56) include a plurality of electromechanical switches (57A, 57B) controllable to switch the interconnection of each reception port (50A, 50B) between at least two different low-noise amplifiers (55A, 55B, 55C).

7. The assembly (20) according to claim 6, wherein:
- the interconnection means (56) form a redundancy loop;
- the redundancy loop and the number of low-noise amplifiers (55A, 55B, 55C) are suitable for providing N:N+P redundancy, where N means the total number of reception ports (50A, 50B) connected to the radiating elements (32A,...,32F) and P means the number of failures of the low-noise amplifiers (55A, 55B, 55C) necessary for a reception port (50A, 50B) to become unusable.

8. The assembly (20) according to any one of the preceding claims, wherein the reception distribution network (42) further includes a thermal control system.

9. The assembly (20) according to claim 8 combined with claim 4, wherein the thermal control system includes a plurality of channels filled with a fluid and arranged on the first and/or second surfaces (51, 52).

10. The assembly (20) according to any one of the preceding claims, further including a plurality of radiofrequency chains (49A,...,49F), each radiofrequency chain (49A,...,49F) being associated with a radiating element (32A,...,32F) and connecting this radiating element (32A,...,32F) to the corresponding reception waveguide (47A,...,47F) and/or to the corresponding emission waveguide (45A,...,45F).

11. A multibeam antenna (12) including a communication module (22) and an emission and reception assembly (20), the emission and reception assembly (20) being according to any one of the preceding claims.

12. The antenna (12) according to claim 11, wherein, when it is placed on a space vehicle (12), the space vehicle having a payload, the housing (34) comprising the emission distribution network (41) and the reception distribution network (42) is arranged outside the space vehicle (12) and the communication module (22) is arranged in the payload (18) of the space vehicle (12).
